# EUROPÄISCHE PATENTSCHRIFT

(11) **EP 0 859 993 B1**
(45) Veröffentlichungstag und Bekanntmachung des Hinweises auf die Patenterteilung: **09.06.1999**
(21) Anmeldenummer: 96945838.9
(22) Anmeldetag: 28.10.1996
(51) Int. Cl.: G06K 19/077

(54) **CHIPMODUL**
CHIP MODULE
MODULE A PUCE

(30) Priorität: 03.11.1995 DE 19541072
(43) Veröffentlichungstag der Anmeldung: 26.08.1998
(73) Patentinhaber: SIEMENS AKTIENGESELLSCHAFT, 80333 München (DE)
(72) Erfinder: HUBER, Michael, D-93152 Nittendorf (DE); STAMPKA, Peter, D-92421 Schwandorf (DE)
(86) Internationale Anmeldenummer: DE9602050
(87) Internationale Veröffentlichungsnummer: WO9716846

(56) Entgegenhaltungen:
- EP-A- 0 676 716
- US-A- 4 625 102

## Beschreibung

Die Erfindung bezieht sich auf ein Chipmodul nach dem Oberbegriff des Anspruchs 1, welches Chipmodul insbesondere in eine Chipkarte einzubauen ist.

Die Anwendungsmöglichkeiten von in der Regel im Scheckkartenformat ausgebildeten Chipkarten sind aufgrund einer hohen funktionalen Flexibilität äußerst vielseitig geworden und nehmen mit der steigenden Rechenleistung und Speicherkapazität der verfügbaren integrierten Schaltungen weiterhin zu. Neben den derzeit typischen Anwendungsfeldern solcher Chipkarten in der Form von Krankenversichertenkarten, Gleitzeiterfassungskarten, Telefonkarten ergeben sich zukünftig insbesondere Anwendungen im elektronischen Zahlungsverkehr, bei der Zugriffskontrolle auf Rechner, bei geschützten Datenspeichern und dergleichen. Es gibt heute verschiedene Möglichkeiten, Chipkarten herzustellen. Bei den meisten Verfahren wird der eigentliche Halbleiterchip zunächst auf ein Chipkartenmodul montiert, der auch die zumeist vergoldeten Kartenkontakte beinhaltet. Üblicherweise werden die Chipkartenmodule auf einem Endlosband beziehungsweise Endlosgrundträger gefertigt, anschließend werden die einzelnen Chipkartenmodule ausgestanzt und in die Chipkarte gebracht. Bei dieser Methode findet keine direkte Befestigung des Chips in der Karte statt, was den Vorteil besitzt, daß die Biegekräfte weitgehend vom Chip abgehalten werden, die bei einer mechanischen Belastung der Chipkarte entstehen können.

Bei der Herstellung von Chipkartenmodulen wird derzeit am häufigsten das sogenannte Draht-Bond-Verfahren angewendet, welches auch dem erfindungsgemäßen Modul zugrunde liegt, und welches beispielsweise aus den FR 2 684 236 A1, DE 42 32 625 A1, GB 2 149 209 A, und DE 38 09 005 A1 bekanntgeworden ist. Hierbei werden die Chipanschlüsse des die eigentliche elektronische Schaltung tragenden Halbleiterchips mit dünnen Bonddrähten mit den einzelnen Kontaktelementen der Kontaktschicht verbunden. Zum Schutz gegen Umwelteinflüsse werden der Halbleiterchip und die Bonddrähte durch eine Vergußmasse abgedeckt. Der Vorteil dieses Herstellungsverfahrens liegt darin, daß es sich weitgehend an das in der Halbleiterindustrie übliche Verfahren zur Verpackung von Chips in Standardgehäusen anlehnt, und dadurch preisgünstiger ist. Der Nachteil bei diesem Verfahren liegt hauptsächlich darin, daß sowohl die Bauhöhe wie auch die Länge und Breite des Moduls deutlich größer ausfallen als beispielsweise beim sogenannten TAB-Modul, bei dem die Anschlußflächen (Pads) des Halbleiterchips mit galvanisch aufgebrachten metallischen Höckern versehen sind, die zur unmittelbaren Befestigung der elektrisch leitenden Kontaktflächen durch Lötverbindung dienen, und somit eine Abdeckung von Bonddrähten nicht erforderlich ist. Für den Einbau des Chipmoduls in die Chipkarte haben sich derzeit drei verschiedene Verfahren durchgesetzt, das Laminierverfahren, das Einsetzen in gefräste Hohlräume, sowie das Montieren in fertig gespritzte Karten. Bei sämtlichen Einbauverfahren besteht beim Kartenhersteller der Nachteil, Chipkartenmodule mit unterschiedlichen Baugrößen, die aus der unterschiedlichen Chipfläche des verwendeten Halbleiterchips resultieren, in die Karte einsetzen zu müssen. Die aufgrund von unterschiedlichen Chipflächen von typischerweise etwa 1 mm² bis 20 mm² resultierende Modulvielfalt führt auch beim Modulhersteller zu erhöhten Materialkosten aufgrund einer verringerten Abnahmemenge pro Modulvariante und zu einem erhöhten Logistikaufwand. Beim Kartenhersteller ergeben sich aufgrund der unterschiedlichen Modultypen verschiedene Abmessungen der Kartenhohlräume für den Einbau des Moduls und damit erhöhte Werkzeugkosten bzw. Verfahrenskosten.

Aus der EP-A-0 676 716 ist ein Chipmodul nach dem Oberbegriff des Anspruches 1 bekannt geworden, bei dem zwischen der äußeren Decklage der Chipkarte und den Kontaktelementen eine Isolationsfolie mit Bondlöchern vorgesehen ist, deren Anzahl der Anzahl der Kontaktelemente entspricht. Mit dieser Anordnung ist es nicht möglich, Halbleiterchips unterschiedlicher Baugröße zu montieren, ohne das Chipmodul konstruktiv zu verändern.

Der Erfindung liegt die Aufgabe zugrunde, ein universell verwendbares Chipmodul für den Einbau in eine beliebige Halbleiterchipvorrichtung, insbesondere Chipkarte zur Verfügung zu stellen, welches unabhängig von der Chipgröße des jeweils verwendeten Halbleiterchips eine einheitliche Baugröße besitzt, wobei das Chipmodul mit einem allenfalls geringfügig höheren Mehraufwand bzw. Mehrkosten herstellbar ist.

Diese Aufgabe wird durch ein Chipmodul gemäß Anspruch 1 gelöst.

Die Erfindung ermöglicht ein universell einsetzbares Modul mit einheitlichen äußeren Abmessungen, welche unabhängig sind von der Größe des jeweils verwendeten Halbleiterchips. Dadurch können sowohl bei der Herstellung des Chipmoduls, als auch beim Einbau des Moduls in die Chipkarte erhebliche Fertigungskosten eingespart werden und der Logistikaufwand in beiden Bereichen verringert werden.

Dem Prinzip der Erfindung folgend kann insbesondere vorgesehen sein, daß die dünne Isolationsfolie an den Stellen der Bondlöcher und/oder an der Stelle des am Chipmodul zu befestigenden Halbleiterchips ausgestanzt ist, und ansonsten über die gesamte Fläche der Kontaktschicht annähernd durchgehend geschlossen ausgebildet ist. Das erfindungsgemäße Chipmodul kann bei allen derzeit im Einsatz befindlichen Kontaktschichten nach ISO-Standard verwendet werden, wobei derzeit hauptsächlich eine Anzahl von sechs oder acht Kontaktelementen üblich ist.

Bei einer besonders bevorzugten Ausführung der Erfindung ist vorgesehen, daß die zwischen der elektrisch leitenden Kontaktschicht und dem Halbleiterchip vorgesehene Isolationsfolie pro zugeordnetem Kontaktelement wenigstens zwei Bondlöcher aufweist. Erforderlichenfalls kann in Abhängigkeit der in der Regel nach ISO-Standards vorbestimmten Anordnung und Geometrie des Kontaktfeldes mit den Kontaktelementen und in Abhängigkeit der tatsächlich verwendeten Chiptypen unter Berücksichtigung der gängigen Montagevorschriften hinsichtlich der Bonddrähte, die insbesondere eine maximale Länge der Bonddrähte vorschreiben, die genaue Geometrie, Anordnung und Anzahl der Bondlöcher für jedes Kontaktelement der Kontaktfläche unterschiedlich gestaltet sein kann. Hierbei ist weiterhin zu berücksichtigen, daß bei der Verwendung eines Klebstoffes zur Befestigung des Halbleiterchips in das Kartenmodul ein unerwünschter Klebstoffauftrag durch die Bondlöcher auf die Rückseite des dem Chipanschluß zugeordneten Kontaktelementes vermieden wird, was durch geeignete Gestaltung und Anordnung der Bondlöcher desselben Kontaktelementes dadurch erreicht werden kann, daß die Kantenränder eines Bondloches durch Adhäsionswirkung gewissermaßen als Fließstop für das Klebstoffmittel wirken, so daß ein separat vorzusehender "Bleed-Stop" zur Verhinderung eines unerwünschten Klebstoffauftrages nicht erforderlich ist.

Bei einer bevorzugten Ausführung der Erfindung kann vorgesehen sein, daß ein insbesondere am Randbereich der Kontaktschicht verbundener und den Halbleiterchip umgebender Träger aus elektrisch isolierendem Material vorgesehen ist. Der Träger kann insbesondere aus einem Glasepoxymaterial hergestellt sein und vorzugsweise eine Stärke von etwa bis zum 125 µm besitzen. Darüber hinaus kann insbesondere bei großflächigen und dadurch bruchempfindlicheren Halbleiterchips zusätzlich ein den Chip umgebender Versteifungsrahmen auf der Isolationsfolie aufgebracht sein.

Gegenüber den verwendeten Schichtstärken der metallischen Kontaktschicht und des Trägers aus elektrisch isolierenden Material kann die zwischen der elektrisch leitenden Kontaktschicht und der Halbleiterschicht angeordnete Isolationsfolie eine wesentlich geringere Stärke besitzen, beispielsweise von deutlich weniger als etwa 30 µm, solange eine ausreichende elektrische Isolationswirkung der Isolationsfolie gegeben ist.

Bei einer weiterhin bevorzugten Ausführung der Erfindung erfolgt die Verbindung des Halbleiterchips mit dem Chipmodul unter Verwendung eines elektrisch isolierenden Klebstoffes, wodurch verhindert werden kann, daß über die Klebstoffschicht ein elektrischer Kurzschluß über die Kontakte des Lesegerätes entsteht. Durch die Verwendung eines beispielsweise nicht Aggefüllten Isolierklebstoffes mit einer Wärmeleitzahl λ von ungefähr 5 W/mK kann in Verbindung mit der stark thermisch isolierenden Isolationsfolie bzw. Isolationsschicht auch ohne Vorsehen einer Chipinsel ein wesentlich verbessertes Delaminationsverhalten im Hinblick auf ein sogenanntes Hot-Melt-Einbauverfahren gewährleistet werden.

Der Isolationsfolie kommt in erster Linie die Wirkung einer elektrisch isolierenden Schicht zwischen Halbleiterchip und Kontaktschicht zu. Darüber hinaus kann bei einer weiterhin bevorzugten Ausführung der Erfindung der Isolationsfolie eine die Verbindung zwischen Halbleiterchip und Kontaktschicht gewährleistende Funktion zu. Hierbei soll die Isolationsfolie zum einen eine möglichst vollflächig gute Haftung zur metallischen Kontaktschicht und zum anderen auf der dieser gegenüberliegenden Seite eine gute Haftung zum Halbleiterchip bzw. zum Epoxytape gewährleisten. Weiterhin soll die Klebe- bzw. Haftverbindung zum Halbleiterchip bzw. zur Metallschicht vermittels der dünnen Isolationsfolie schnell und einfach hergestellt werden können und ausreichende Langzeitstabilität besitzen. Bei einer bevorzugten Ausführung der Isolationsfolie kann dieser die Wirkung einer auf Druck empfindlichen Klebstoffschicht dergestalt zukommen, daß der während des Auflaminierens der Kontaktschicht und des Epoxytapes erzeugte Walzendruck eine zur Kraftwirkungslinie bzw. -richtung senkrecht erzeugte Scherspannung in der druckempfindlichen Klebstoffschicht bzw. Isolationsfolie erzeugt. Die Klebstoffschicht wird in dieser Richtung vorzugsweise durch eine entsprechende Ausrichtung von Molekülketten innerhalb der Klebstoffschicht mikroplastisch. Dies reicht aus, um eine Mikroformgebung und damit Anpassung der Oberfläche der Klebstoffschicht zum jeweiligen Verbindungspartner zu erzeugen und somit eine ausreichende Haftfestigkeit zu gewährleisten. Als Materialien für eine solcherart als druckempfindliche Klebstoffschicht geeignete Isolationsfolien sind beispielsweise Acrylate, Naturstoffe (beispielsweise Kautschuke), Silikone, Styrol-Copolymerisate (beispielsweise Butadiene), Isoprene und dergleichen geeignet. Hierbei kann die auch als druckempfindliche Klebstoffschicht wirkende Isolationsfolie sowohl einlagig, als auch mehrlagig ausgebildet sein. Bei einem Mehrlagenaufbau kann eine mittlere Lage die Trägerfunktion für die einzelnen Klebstoffschichten übernehmen. Für die Mittellage zur Ausübung der Trägerfunktion eignen sich insbesondere Thermoplast-Folien. Der Einsatz der Isolationsfolie auch als Klebstoffschicht für den Halbleiterchip erübrigt die Aufbringung eines weiteren Chipklebers. Bei solchen zusätzlichen Chipklebstoffen, die in der Regel in flüssiger oder zähflüssiger Konsistenz aufgetragen werden, besteht generell der Nachteil, daß bei ungeeigneter Dosierung oder bei Prozeßunregelmäßigkeiten Produktionsausfälle resultieren können. Bei einer zu hohen Dosierung des aufgetragenen Chipklebstoffes besteht beispielsweise die Gefahr, einige für die Bondkontaktierung notwendigen Bondlöcher zu verkleben, wodurch sie unbrauchbar wären, wohingegen bei einer zu geringen Dosierung des Klebstoffes auf der Isolationsfolie eine unzureichende Chipfixierung auf dem perforierten Untergrund erfolgt. Außerdem besteht bei einem Auftrag von flüssigem Chipklebstoff die Gefahr einer Veränderung der Form und Lage der benötigten Bondlöcher, was wiederum zu erhöhten Produktionsausfällen führen kann oder eine höhere Prozeßkontrolle erforderlich macht.

Weitere Merkmale, Vorteile und Zweckmäßigkeiten der Erfindung ergeben sich aus der nachfolgenden Beschreibung von Ausführungsbeispielen anhand der Zeichnung. Es zeigt:
- Figur 1: eine schematische Ansicht des Chipmoduls gemäß Erfindung mit den drei Bestandteilen einer Kontaktschicht mit Kontaktelementen, einer dünnen Isolationsfolie, und einem Träger aus elektrisch isolierenden Material;
- Figur 2: eine schematische Draufsicht eines Chipmoduls gemäß einem Ausführungsbeispiel der Erfindung mit einem kleinflächigen Halbleiterchip; und
- Figur 3: eine schematische Draufsicht eines Chipmoduls gemäß einem Ausführungsbeispiel der Erfindung mit einem großflächigen Halbleiterchip.

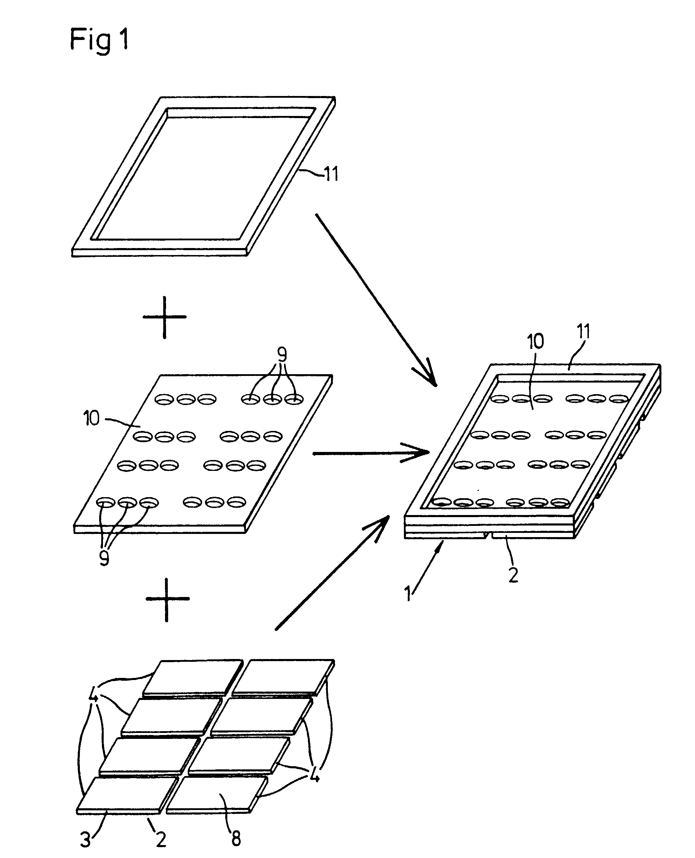

Das in den Figuren 1 bis 3 dargestellte Chipmodul 1 besitzt eine in der Regel nach einem ISO-Standard mit genormten Abmessungen versehene und eine Stärke von etwa 30 µm bis etwa 70 µm aufweisende metallische Kontaktschicht 2 mit auf der Vorderseite mit Kontaktflächen 3 versehenen Kontaktelementen 4 und einen in dem Chipmodul zu befestigenden Halbleiterchip 7, welcher auf seiner Hauptfläche 5 der Übersichtlichkeit halber nicht näher dargestellte Chipanschlüsse bzw. Pad-Anschlußflächen besitzt, die mittels Bonddrähten 6 mit der Rückseite 8 des dem jeweiligen Chipanschlusses zugeordneten Kontaktelementes 4 elektrisch verbunden sind. Erfindungsgemäß ist vorgesehen, daß zwischen der elektrisch leitenden Kontaktschicht 2 und dem Halbleiterchip 7 eine mit einer Vielzahl von Bondlöchern 9 versehene, dünne Isolationsfolie 10 aus elektrisch isolierendem Material vorgesehen ist. Die Bondlöcher sind hinsichtlich Anordnung, Form, Anzahl, sowie Zuordnung zu einem bestimmten Kontaktelement 4 der Kontaktschicht 2 derart beschaffen, daß bei einer beliebigen Lage und Grundfläche des befestigten Halbleiterchips 7 eine Kontaktierung der Chipanschlüsse mittels der Bonddrähte 6 unter Berücksichtigung der gängigen Montagevorschrift, d.h. vorbestimmten maximalen Bonddrahtlänge, mit einem jeweils zugehörenden Kontaktelement 4 der Kontaktschicht 2 bewerkstelligt werden kann. Wie in den Figuren dargestellt ist die dünne Isolationsfolie 10 an den Stellen der Bondlöcher 9 ausgestanzt, und ansonsten über die gesamte Fläche der Kontaktschicht 2 annähernd durchgehend geschlossen ausgebildet. Bei einer weiteren Ausführungsform, welche in den Figuren nicht näher dargestellt ist, kann darüber hinaus die dünne Isolationsfolie 10 an der Stelle des zu befestigenden Halbleiterchips 7 mit einer der Grundfläche des Halbleiterchips 7 entsprechenden Ausstanzung versehen sein. In diesem Fall kann der Halbleiterchip in die vorgesehene Ausstanzung der Isolationsfolie gesetzt und direkt auf der Rückseite 8 der Kontaktschicht 2 befestigt werden, beispielsweise durch Die-Bonding.

Gemäß Figur 1 kann ein insbesondere am Randbereich der Kontaktschicht 2 verbundener und den Halbleiterchip 7 umgebender Träger 11 aus Glasepoxy-Material vorgesehen sein, der auch als Stützrahmen des Chipmoduls dient und mit Klebeflächen versehen in den beispielsweise gefrästen Hohlraum der späteren Chipkarte montiert wird.

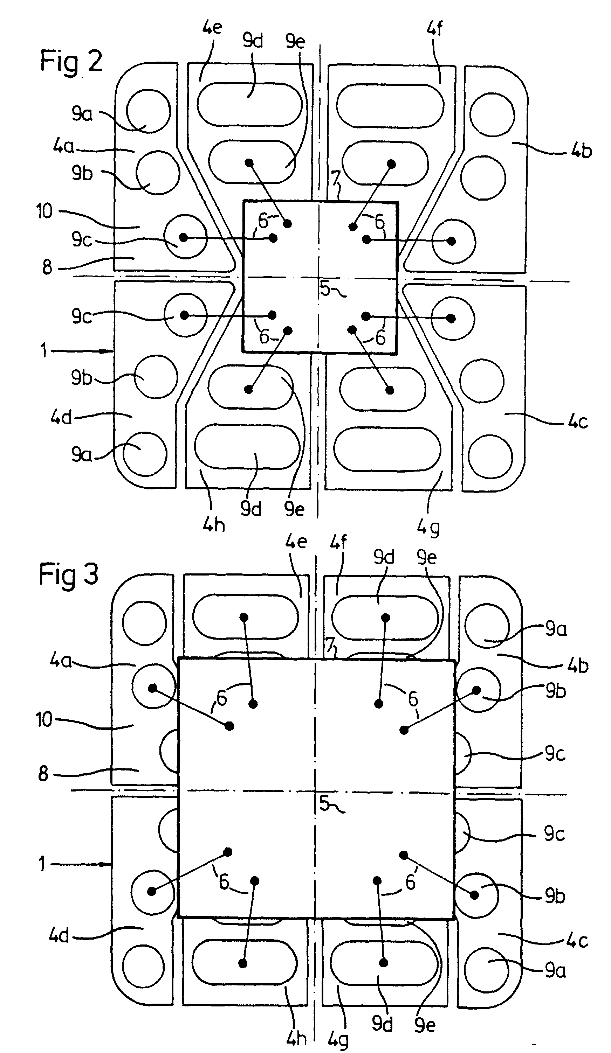

Die Figuren 2 und 3 zeigen in schematischen Aufsichten nähere Einzelheiten eines insbesondere bevorzugten Ausführungsbeispieles der Erfindung, bei dem das Chipmodul 1 eine Kontaktschicht 2 mit einer Anzahl von acht Kontaktelementen 4a bis 4h besitzt, wobei gemäß Figur 2 ein relativ kleinflächiger Halbleiterchip 7a, und gemäß Figur 3 ein relativ großflächiger Halbleiterchip 7b montiert ist. Wie dargestellt sind die Bondlöcher 9 der dünnen Isolationsfolie 10 so beschaffen, daß bei den Kontaktelementen 4a bis 4d jeweils eine Anzahl von drei Bondlöchern 9a, 9b, 9c mit kreisrunder Querschnittsform vorgesehen sind, deren aufeinanderfolgende Anordnung der Mittelpunkte im wesentlichen annähernd der Formgebung des zugehörenden Kontaktelementes folgt, und bei den Kontaktelementen 4e bis 4h jeweils eine Anzahl von zwei Bondlöchern 9d, 9e mit länglichen Querschnittsformen vorgesehen sind, wobei die Abmessungen des Bondloches in Längserstreckung mit zunehmendem Abstand von der Mitte der Kontaktschicht zunehmen. Auf diese Weise kann eine Kontaktierung der Chipanschlüsse vermittels der Bonddrähte 6 mit einem jeweils zugehörenden Kontaktelement vermittels eines günstig gelegenen Bondloches unabhängig von der Grundfläche des Halbleiterchips bewerkstelligt werden.

## Patentansprüche

1. Chipmodul mit einer eine Vielzahl von auf einer Vorderseite mit Kontaktflächen (3) versehenen, untereinander elektrisch isolierten Kontaktelementen (4) aufweisenden und aus elektrisch leitendem Material gefertigten Kontaktschicht (2), einem befestigten Halbleiterchip (7) mit auf der Hauptfläche (5) des Halbleiterchips (7) angeordneten Chipanschlüssen, die über eine maximale Montagelänge besitzende Bonddrähte (6) mit einer Rückseite des dem jeweiligen Chipanschluß zugeordneten Kontaktelementes (4) elektrisch verbunden sind, und einer zwischen der elektrisch leitenden Kontaktschicht (2) und dem Halbleiterchip (7) mit einer die Anzahl der Chipanschlüsse übersteigenden Vielzahl von Bondlöchern (9) versehenen Isolationsfolie (10) aus elektrisch isolierendem Material,
dadurch gekennzeichnet, daß
die Bondlöcher (9) hinsichtlich deren Anordnung, Form, Anzahl, sowie Zuordnung zu einem bestimmten Kontaktelement (4) der Kontaktschicht (2) derart beschaffen sind, daß für jedes Kontaktelement (4) mehrere Bondlöcher (9) vorgesehen sind, wobei durch jeweils eines dieser Bondlöcher (9) ein Bonddraht zum Kontaktelement (4) geführt ist, so daß bei einer beliebigen Lage und Grundfläche des befestigten Halbleiterchips (7) eine Kontaktierung der Chipanschlüsse vermittels der Bonddrähte (6) mit einem jeweils zugehörenden Kontaktelement (4) der Kontaktschicht (2) bewerkstelligt ist.

2. Chipmodul nach Anspruch 1, dadurch gekennzeichnet, daß die zwischen der elektrisch leitenden Kontaktschicht (2) und dem Halbleiterchip (7) vorgesehene dünne Isolationsfolie (10) pro zugeordnetem Kontaktelement (4) wenigstens zwei Bondlöcher (9) aufweist.

3. Chipmodul nach Anspruch 1 oder 2, dadurch gekennzeichnet, daß jeder Bonddraht (6) für die elektrische Kontaktierung der Chipanschlüsse mit den Kontaktflächen (3) der Kontaktschicht (2) eine maximale Montagelänge von etwa 3 mm aufweist.

4. Chipmodul nach Anspruch 1 bis 3, dadurch gekennzeichnet, daß ein insbesondere am Randbereich der Kontaktschicht (2) verbundener und den Halbleiterchip (7) umgebender Träger (11) aus elektrisch isolierendem Material vorgesehen ist.

5. Chipmodul nach Anspruch 4, dadurch gekennzeichnet, daß der Träger (11) aus Glasepoxy-Material hergestellt ist und eine Stärke von etwa bis zu 125 µm besitzt.

6. Chipmodul nach Anspruch 1 bis 5, dadurch gekennzeichnet, daß die zwischen der elektrisch leitenden Kontaktschicht (2) und dem Halbleiterchip (7) angeordnete Isolationsfolie (10) eine Stärke von weniger als etwa 30 µm besitzt.

7. Chipmodul nach Anspruch 1 bis 6, dadurch gekennzeichnet, daß der Halbleiterchip (7) vermittels einem elektrisch isolierenden Klebstoff in das Chipmodul (1) eingeklebt ist.

8. Chipmodul nach Anspruch 1 bis 7, dadurch gekennzeichnet, daß die Kontaktschicht (2) eine Anzahl von sechs oder acht Kontaktelementen (4) besitzt.

9. Chipmodul nach Anspruch 1 bis 8, dadurch gekennzeichnet, daß die Isolationsfolie (10) an den Stellen der Bondlöcher (9) und an der Stelle des am Chipmodul (1) zu befestigenden Halbleiterchips (7) ausgestanzt ist, und ansonsten über die gesamte Fläche der Kontaktschicht (2) annähernd durchgehend geschlossen ausgebildet ist.

10. Chipmodul nach Anspruch 1 bis 9, dadurch gekennzeichnet, daß die dünne Isolationsfolie (10) gleichzeitig als Haft-bzw. Klebstoffschicht wirkt.

11. Chipmodul nach Anspruch 10, dadurch gekennzeichnet, daß die dünne Isolationsfolie (10) aus einem Haft- bzw. Klebstoffmaterial besteht, dessen Haft- bzw. Klebeeigenschaften von dem Grad eines beaufschlagten mechanischen Druckes abhängen.

## Claims

1. Chip module having a contact layer (2) made of electrically conductive material, which has a multiplicity of contact elements (4), provided on a front side with contact areas (3), having an attached semiconductor chip (7), which has chip terminals which can be arranged on the main area (5) of the semiconductor chip (7) and are electrically connected by means of bonding wires (6) of a maximum mounting length to a back side of the contact element (4) assigned to the respective chip terminal, and having an insulating film (10) of electrically insulating material, which is provided with a multiplicity of bonding holes (9) exceeding the number of chip terminals, between the electrically conductive contact layer (2) and the semiconductor chip (7), characterized in that the bonding holes (9) are made with regard to their arrangement, shape, number and assignment to a particular contact element (4) of the contact layer (2) in such a way that a plurality of bonding holes are provided for each contact element (4), a bonding wire being led respectively through one of these bonding holes (9) to the contact element (4), so that, with any desired position and base area of the attached semiconductor chip (7), an electrical bonding of the chip terminals with a respectively associated contact element (4) of the contact layer (2) is accomplished by means of the bonding wires (6).

2. Chip module according to Claim 1, characterized in that the thin insulating film (10) provided between the electrically conductive contact layer (2) and the semiconductor chip (7) has at least two bonding holes (9) per assigned contact element (4).

3. Chip module according to Claim 1 or 2, characterized in that each bonding wire (6) has for the electrical bonding of the chip terminals with the contact areas (3) of the contact layer (2) a maximum mounting length of about 3 mm.

4. Chip module according to Claims 1 to 3, characterized in that a carrier (11) of electrically insulating material is provided, in particular connected to the border region of the contact layer (2) and surrounding the semiconductor chip (7).

5. Chip module according to Claim 4, characterized in that the carrier (11) is produced from glass epoxy material and has a thickness of about up to 125 mm.

6. Chip module according to Claims 1 to 5, characterized in that the insulating film (10) arranged between the electrically conductive contact layer (2) and the semiconductor chip (7) has a thickness of less than about 30 mm.

7. Chip module according to Claims 1 to 6, characterized in that the semiconductor chip (7) is adhesively bonded into the chip module (1) by means of an electrically insulating adhesive.

8. Chip module according to Claims 1 to 7, characterized in that the contact layer (2) has six or eight contact elements (4).

9. Chip module according to Claims 1 to 8, characterized in that the insulating film (10) is punched out at the locations of the bonding holes (9) and at the location of the semiconductor chip (7) to be attached on the chip module (1), and is otherwise formed such that it is closed virtually continuously over the entire surface area of the contact layer (2).

10. Chip module according to Claims 1 to 9, characterized in that the thin insulating film (10) acts at the same time as a bonding layer or adhesive layer.

11. Chip module according to Claim 10, characterized in that the thin insulating film (10) consists of a bonding material or adhesive material, the bonding or adhesive properties of which depend on the degree of a mechanical pressure applied.

## Revendications

1. Module à puce comportant une couche (2) de contact en un matériau conducteur de l'électricité, comportant une pluralité d'éléments (4) de contact munis, sur un côté avant, de surfaces (3) de contact et isolés électriquement les uns des autres, une puce (7) à semi-conducteur fixée, comportant des raccords de puce qui sont disposés sur la surface (5) principale de la couche (7) à semi-conducteur et qui sont reliés du point de vue électrique, par l'intermédiaire de fils (6) de bonding ayant une longueur de montage maximum à une face arrière de l'élément (4) de contact associé aux raccords de puce concernés, et une feuille (10) isolante en matériau isolant de l'électricité, disposée entre la couche (2) de contact conductrice de l'électricité et la puce (7) à semi-conducteur, et munie d'une pluralité de trous (9) de bonding dont le nombre est supérieur à celui des raccords de puce, caractérisé en ce que la disposition des trous (9) de bonding, leur forme, leur nombre, ainsi que leur association à un élément (4) de contact déterminé de la couche (2) de contact sont tels qu'il est prévu pour chaque élément (4) de contact plusieurs trous (9) de bonding, un fil de bonding étant guidé à l'élément (4) de contact chaque fois par l'un de ses trous (9) de bonding, si bien que l'on obtient pour une position et une surface de base quelconque de la puce (7) à semi-conducteur fixée un contact des raccords de puce, au moyen des fils (6) de bonding, chaque fois à un élément (4) de contact associé de la couche (2) de contact.

2. Module à puce suivant la revendication 1, caractérisé en ce que la mince feuille (10) isolante, prévue entre la couche (2) de contact conductrice de l'électricité et la couche (7) à semi-conducteur, a au moins deux trous (9) de bonding par élément (4) de contact associé.

3. Module à puce suivant la revendication 1 ou 2, caractérisé en ce que chaque fil (6) de bonding prévu pour le contact électrique des raccords de puce aux surfaces (3) de contact de la couche (2) de contact a une longueur de montage maximum d'environ 3 mm.

4. Module à puce suivant la revendication 1 à 3, caractérisé en ce qu'il est prévu un support (11) en matériau isolant de l'électricité, relié notamment à la zone de bord de la couche (2) de contact et entourant la puce (7) à semi-conducteur.

5. Module à puce suivant la revendication 4, caractérisé en ce que le support (11) est fabriqué en un matériau époxy vitreux et a une épaisseur pouvant aller jusqu'à environ 125 µm.

6. Module à puce suivant la revendication 1 à 5, caractérisé en ce que la feuille (10) isolante disposée entre la couche (2) de contact conductrice de l'électricité et la puce (7) à semi-conducteur a une épaisseur de moins de 30 µm environ.

7. Module à puce suivant la revendication 1 à 6, caractérisé en ce que la puce (7) à semi-conducteur est collée dans le module (1) à puce au moyen d'une colle isolante de l'électricité.

8. Module à puce suivant la revendication 1 à 7, caractérisé en ce que la couche (2) de contact a un nombre d'éléments (4) de contact de six ou huit.

9. Module à puce suivant la revendication 1 à 8, caractérisé en ce que la feuille (10) isolante est découpée aux emplacements des trous (9) de bonding et à l'emplacement de la puce (7) à semi-conducteur fixée au module (1) à puce et, pour le reste, réalisée en étant fermée à peu près de manière continue sur toute la surface de la couche (2) de contact.

10. Module à puce suivant la revendication 1 à 9, caractérisé en ce que la mince feuille (10) isolante agit en même temps comme couche d'adhérence ou couche de colle.

11. Module à puce suivant la revendication 10, caractérisé en ce que la mince feuille (10) isolante est en un matériau adhésif ou de colle dont les propriétés adhésives ou de colle dépendent du niveau d'une pression mécanique exercée.
